# EUROPEAN PATENT APPLICATION

(11) **EP 1 114 792 A2**
(43) Date of publication of application: **11.07.2001**
(21) Application number: 00127725.0
(22) Date of filing: 18.12.2000
(51) Int. Cl.: C01B 21/064, C23C 16/34

(54) **Cubic boron nitride and its gas phase synthesis method**

(30) Priority: 27.12.1999 JP 36897899; 17.02.2000 JP 2000045069; 16.11.2000 JP 2000348883
(71) Applicant: NATIONAL INSTITUTE FOR RESEARCH IN INORGANIC MATERIALS, Tsukuba-shi, Ibaraki 305 (JP)
(72) Inventor: Matsumoto, Seiichirou, Tsukuba-shi, Ibaraki 305-0044 (JP); Wenjun, Zhang, Tsukuba-shi, Ibaraki 305-0044 (JP)
(74) Representative: Hartz, Nikolai F., Dr.

(57) **Abstract**

Cubic boron nitride which is obtained from a gas phase without using an ultra-high pressure and which distinctly shows, in the Raman spectrum, either the characteristic scattering peak of cubic boron nitride by phonons of a longitudinal optical mode at 1305 ± 35 cm⁻¹ or the characteristic scattering peak of cubic boron nitride by phonons of a transverse optical mode at 1056 ± 35 cm⁻¹, or the both characteristic scatterings.

## Description

The present invention relates to a new-type cubic boron nitride and its gas phase synthesis method.

Cubic boron nitride (c-BN) is expected to be a potentially useful functional material in view of its characteristics such that it has the highest hardness and thermal conductivity next to diamond, it has the low reactivity with iron-family metals, and it has a wide band gap and can be a semiconductor. Its crystal grains have already been synthesized industrially under a high pressure of tens of thousands atm by using a high pressure apparatus. However, with this method, it is difficult to control its form, and particularly it is very difficult to synthesize cubic boron nitride in the form of a film.

On the other hand, attempts have been done to synthesize it from a gas phase under a pressure lower than 1 atm. These methods are classified into two groups. One is physical vapor deposition methods (PVD) by utilizing ion bombardment to a substrate, including gas-activated reactive evaporation, bias-sputtering and bias ECR. In these methods, the pressure in a reaction chamber is as low as at most 10⁻¹ Torr.

The other is chemical vapor deposition methods (CVD method), wherein a boron source such as diborane, boron trichloride, boron trifluoride, aminoborane, or borazine, and a nitrogen source such as ammonia or nitrogen, are reacted. To suppress the formation of hexagonal boron nitride, atomic hydrogen generated by a plasma or a heated filament, is utilized in many cases.

In the above CVD methods, the pressure in the reaction chamber is usually so high as from 10 to 160 Torr except for some cases. This CVD method without substrate-biasing is unestablished since a follow-up experiment has not succeeded. By CVD methods with substrate-biasing under a pressure of from 10⁻³ to 10⁻¹ Torr, synthesis of cubic boron nitride has been reported.

However, cubic boron nitrides obtained in any of the above methods are usually a mixture with e.g. hexagonal boron nitride, or have poor crystal quality, and X-ray diffraction peaks of cubic boron nitride are not detected or are very broad, although an absorption can be seen in the region of from 1050 to 1100 cm⁻¹ in the infrared absorption spectrum. In infrared spectroscopy, the absorption peak of cubic boron nitride is seen in the region of from 1050 to 1100 cm⁻¹, and the absorption peak of hexagonal-type boron nitrides, such as hexagonal boron nitride, turbostratic boron nitride, or amorphous boron nitride is seen in the region of from 1360 to 1400 cm⁻¹ and in the vicinity of 800 cm⁻¹, and it is considered that the ratio of cubic boron nitride and hexagonal-type boron nitrides corresponds to the ratio of the absorbance of the peak at from 1050 to 1100 cm⁻¹ to the absorbance of the peak at from 1360 to 1400 cm⁻¹.

On the other hand, it is said that cubic boron nitride synthesized by high pressure methods shows a Raman scattering peak by phonons of a longitudinal optical mode at about 1305 cm⁻¹ and a peak by phonons of a transverse optical mode at about 1056 cm⁻¹, and the intensity ratio of these two changes by the relation between the optical axis of the excitation light and the crystal axis. The peak position of the Raman scattering changes by e.g. stress in the crystal, crystal defects and the size of the crystal, and the peak shift is considered to be a level of ±45 cm⁻¹ at the most. Further, the full width at half maximum (FWHM) of the Raman scattering peak is about 5 cm⁻¹ for a single crystal of cubic boron nitride having a high quality and a size of from 1 to 2 mm obtained by a high pressure method, and it becomes broader if the crystal size becomes small or crystal defects increase.

In the case of a cubic boron nitride film obtained by the conventional gas phase synthesis, the crystal size is several nm, and the Raman peaks has not been observed. Here, the crystal size was estimated by FWHM of the X-ray diffraction peaks or by electron microscope observation, and the FWHM of 111 reflection by CuKα ray is about 3° in 2 *θ* when the crystal size is 5 nm, and the higher the index, the broader. The appearance of the Raman peaks indicates high crystal quality. Gas phase synthesis of cubic boron nitride distinctly showing these scattering peaks and proving to be truly cubic boron nitride by other charaterization methods also, has not been reported.

By known literatures, S. Manorama et al, J. Phys. D: Appl. Phys. 26(1993) 1793; K. Liao and W. Wang, phys. stat. sol. (a) 145(1994) K25; K. Liao and W. Wang, phys. stat. sol. (a) 151(1995) K1; Y. Guo et al, phys. stat. sol. (a) 143(1994) K13; F. Zhang et al, Appl. Phys. Lett. 65(1994) 971 and Z. Song et al, Appl. Phys. Lett. 65(1994) 2669, with respect to the synthesis of cubic boron nitride, success in follow-up experiments has not been reported, and the success is very questionable. Further, in T.Werninghaus et al, Appl. Phys. Lett. 70(1987) 958, measurement of the Raman peak of a cubic boron nitride film has been reported. However, the intensity is weak, and it is difficult to consider that the cubic boron nitride film shows a distinct peak. Accordingly, it can be stated that synthesis of cubic boron nitride of high quality presenting distinct Raman peaks as mentioned above has not been successfully carried out by the conventional low-pressure synthesis methods.

It has been known that confirmation of cubic boron nitride has to be carried out by at least three conventional methods including X-ray diffraction, infrared spectroscopy and compositional analysis, and the Raman spectroscopy is required to confirm cubic boron nitride of high quality.

The present inventors have invented a method for synthesizing high-density boron nitride by means of plasma CVD method employing boron trifluoride and a nitrogen-containing gas as starting materials before (JP-A-8-208207). However, it was not cubic boron nitride, but turbostratic boron nitride, in view of a crystal structure.

Under these circumstances, the present invention has been made to overcome the above problems, and to provide a method for synthesizing cubic boron nitride having high crystal quality from a gas phase.

The present inventors have found that cubic boron nitride having good crystal quality can be obtained by using fluorine gas or a fluorine-containing gas species as one component of starting materials, and by using substrate-biasing, and the present invention has been accomplished.

Now, the present invention will be described in detail with reference to the preferred embodiments.

In the accompanying drawings:

Figure 1 is a schematic cross-sectional view illustrating an apparatus employing a direct-current plasma jet to be used in the method for synthesizing the cubic boron nitride of the present invention.

Figure 2 is a schematic cross-sectional view illustrating an apparatus using a microwave plasma to be used in the method for synthesizing the cubic boron nitride of the present invention.

Figure 3 is a graph illustrating a X-ray diffraction pattern (by CuKα) of the cubic boron nitride obtained in Example 1 of the present invention.

Figure 4 is a graph illustrating an infrared absorption spectrum of the cubic boron nitride obtained in Example 1 of the present invention.

Figure 5 is a graph illustrating a Raman spectrum of the cubic boron nitride obtained in Example 1 of the present invention.

Figures 6(a) and 6(b) are graphs illustrating the result of the compositional analysis by EPMA of the cubic boron nitride obtained in Example 1 of the present invention.

Figure 7 is a graph illustrating a Raman spectrum of the cubic boron nitride obtained in Example 2 of the present invention.

Figure 8(a) is a photograph illustrating an image by atomic force microscopy of the cubic boron nitride obtained in Example 3 of the present invention, and Figure 8(b) is a photograph illustrating an image by scanning electron microscopy of the ruptured cross-section of a cubic boron nitride film obtained under substantially the same synthesis conditions as in Example 3.

The cubic boron nitride of the present invention is obtained from a gas phase without using high pressure, and distinctly shows, in the Raman spectrum, either the characteristic scattering peak of c-BN by phonons of the longitudinal optical mode in the vicinity of 1305 cm⁻¹ or the characteristic scattering peak of c-BN by phonons of the transverse optical mode in the vicinity of 1056 cm⁻¹, or the both characteristic scattering peaks. The appearance of these Raman scattering peaks is an index indicating high crystal quality of the cubic boron nitride. In the case of the cubic boron nitride of the present invention, the peak position of the Raman scattering peak changes within a range of ±35 cm⁻¹, and the FWHM is at most from 75 to 100 cm⁻¹. However, in a case where the cubic boron nitride has a higher crystallinity, the peak shift is at most ±20 cm⁻¹, and the FWHM is at most 50 cm⁻¹.

When the crystallinity of the cubic boron nitride of the present invention is high, crystal shapes or crystal faces can be observed by atomic force microscopy, by tunneling microscopy, by scanning electron microscopy, by optical microscopy, or by visual observation.

The present invention further provides a method for synthesizing the cubic boron nitride from a gas phase, which comprises activating a boron source gas and a nitrogen source gas by using a plasma to deposit boron nitride, wherein fluorine gas or a fluorine-containing gas species is used as one component of the gas phase, and substrate-biasing is used. According to the synthesis method of the present invention, the above cubic boron nitride can easily be produced in the form of a film.

### Material gas

With respect to the material gas used in the synthesis method of the present invention, as a boron source, at least one compound selected from the group consisting of boron hydrides such as diborane and decaborane, of boron halides such as boron trichloride and boron trifluoride, of borohydrides such as sodium borohydride, of borofluorides such as ammonium borofluoride, of organic boron compounds such as triethoxyboron, or the like, is used. As a nitrogen source, at least one member selected from the group consisting of nitrogen gas, of hydrides of nitrogen such as ammonia and hydrazine, of fluorides of nitrogen such as nitrogen trifluoride and nitrogen tetrafluoride, or the like, is used.

The boron source gas and the nitrogen source gas react to deposit boron nitride. Here, the gases are selected so that fluorine is surely present in the gas phase. In the case where no fluorine is contained in the above material gas species, fluorine gas, hydrogen fluoride, halogen fluoride such as chlorine trifluoride or bromine trifluoride, or a halide of an inert gas such as xenon fluoride, can be added to the gas phase, or fluorine obtained by decomposition of an organic fluorine compound such as tetrafluoromethane, of a fluorine compound such as sulfur hexafluoride, sulfur tetrafluoride, silicon tetrafluoride, phosphorous pentafluoride, or tangusten hexafluoride or another metal fluoride, can be added to the gas phase, in addition to the above compounds.

Further, an inert gas such as argon or helium, or a hydrogen gas can be optionally added to the gas phase with a purpose of controlling the plasma, or controlling the effect of the fluorine gas. Instead of using separate chemical species of nitrogen and boron, a single chemical species such as amine borane, borazine, aminoborane, or dimethylaminoborane can be added to the gas phase. The optimum flow rates of such material gases widely vary depending upon the type of the plasma, the method for generating the plasma, the size of the synthesis apparatus, the synthesis pressure, and the like. However, excess of hydrogen relative to fluorine is undesirable, and the ratio of hydrogen to fluorine in the number of atoms in the gas phase is preferably at most 2, although it depends on the degree of decomposition of the material gases.

### Type of plasma

In the synthesis method of the present invention, the plasma to be used can be either of non-equilibrium or of equilibrium (thermal), and the electric power source for generating the plasma can be any of direct current, low-frequency alternating current, high-frequency current or microwave. Further, the coupling with the reactor can be any of capacitive coupling, inductive coupling, coupling by an antenna, coupling by a resonator, surface-wave excitation, or the like.

### Reaction pressure

In the synthesis method of the present invention, the pressure of the gas phase is from 10⁻⁶ to 10² atm, and it is preferably from 10⁻⁵ to 1 atm in view of the deposition rate and handling easiness.

### Substrate

In the synthesis method of the present invention, the substrate on which boron nitride is deposited, can be any of a semiconductor such as silicon, an insulator such as quartz, or a metal such as tungsten carbide or molybdenum, and it is not particularly limited thereto.

### Substrate temperature

In the synthesis method of the present invention, since an ion bombardment by substrate-biasing is utilized, the temperature of the substrate can be in a wide range of from room temperature to 1400°C, and it is particularly preferably from 600 to 1300°C for synthesizing the cubic boron nitride having high crystal quality.

### Substrate-biasing

In the synthesis method of the present invention, substrate-biasing is required to form cubic boron nitride, and negative direct current biasing or self-biasing by radio-frequency electric power can be employed. The range of the bias voltage is from -5 to -400 V, although it varies depending upon many conditions such as the method for generating the plasma, the gas composition, the gas pressure, the plasma density and the plasma potential.

Fluorine plays an important roll in the synthesis method of the present invention. However, its detailed role is unclear. It is considered that fluorine having extremely high reactivity may remove the sp² bonds in the forming boron nitride, so that the cubic boron nitride is likely to form.

Now, the present invention will be described in further detail with reference to examples. However, it should be understood that the present invention is by no means restricted such specific examples.

A direct current plasma jet was employed in Example 1 and a microwave plasma was employed in Example 2. However, as mentioned above, any of plasmas by radio-frequency discharge, low-frequency alternating current, or the like, and either of a thermal plasma or a non-equilibrium plasma can be employed.

### EXAMPLE 1

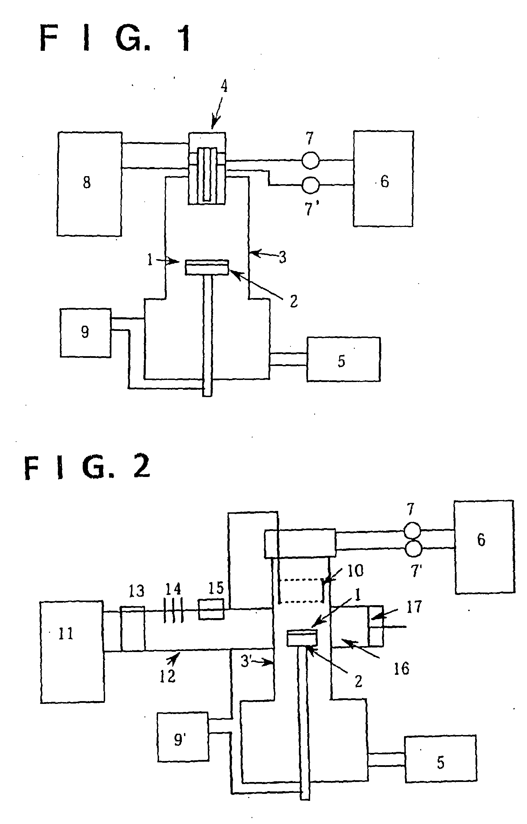

In a direct current plasma jet CVD apparatus as shown in Figure 1, a silicon substrate 1 was put on a substrate holder 2, and a reaction chamber 3 was evacuated to 0.01 Torr by an evacuation pump 5. Then, from a gas supplier 6, 20 slm of Ar, 1 slm of N₂ and 5 sccm of H₂ were flowed through a valve 7, and 30 sccm of 10% BF₃/Ar was flowed through a valve 7', and electric power of 5kW from a direct-current power supply 8 was supplied to a plasma torch 4, to generate a plasma. Direct-current bias of -80 V was applied to the substrate 1 by a direct-current biasing power supply 9, followed by synthesis at a substrate temperature of 1000°C under 50 Torr for 10 minutes to obtain a cubic boron nitride film on the substrate 1.

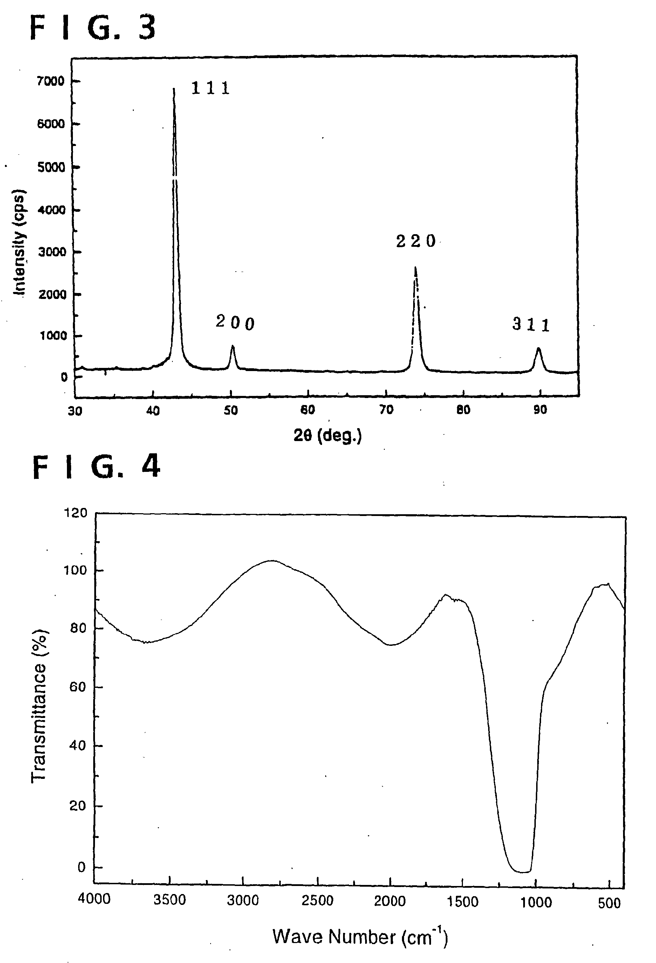

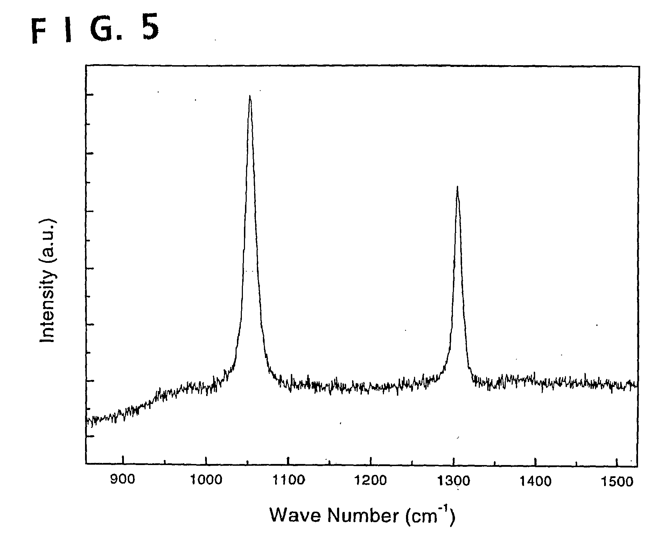

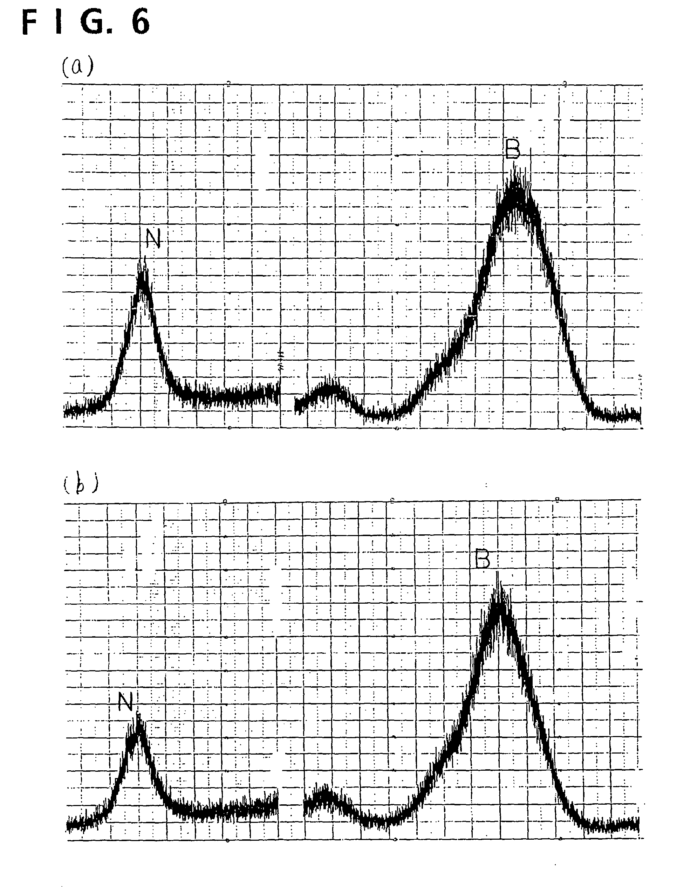

Of the cubic boron nitride obtained by the above method, the X-ray diffraction pattern is shown in Figure 3. The FWHM of the 111, 200, 220 and 311 reflections are 0.49°, 0.65°, 0.62° and 0.88°, respectively. The infrared absorption spectrum is shown in Figure 4. The Raman spectrum is shown in Figure 5. This is measured by back scattering geometry by using an argon ion laser of 514.5 nm. The values of FWHM of the peaks at 1305 cm⁻¹ and at 1054 cm⁻¹ are 10.4 cm⁻¹ and 14.8 cm⁻¹, respectively. The results of the composition analysis by electron probe microanalysis (EPMA) are shown in Figure 6.

It is evident that 111, 200, 220 and 311 reflections of cubic boron nitride distinctly appeared from Figure 3, that the absorption of the Reststrahlen of cubic boron nitride significantly appeared in the vicinity of 1100 cm⁻¹ from Figure 4, that the scattering peaks of cubic boron nitride by phonons of the longitudinal optical mode at 1305 cm⁻¹ and by phonons of the transverse optical mode at 1054 cm⁻¹ distinctly appeared from Figure 5. In Figure 4, it is difficult to confirm the presence of an absorption in the region of from 1360 to 1400 cm⁻¹ since the absorption attributable to cubic boron nitride is strong and broad, and also it is difficult to confirm an absorption in the vicinity of 800 cm⁻¹ due to the interference fringes of the light by the film. The proportion of the hexagonal boron nitride, the turbostratic boron nitride and the amorphous boron nitride is small, and considered to be at most 10%.

Further, Figure 6(a) illustrates the results of analysis of boron and nitrogen in the sample obtained by the method of the present invention, and Figure 6(b) illustrates the results of analysis of a pyrolytic boron nitride as a standard sample. From these Figures, it is known that the sample obtained by the present method is composed by nitrogen and boron with the ratio of approximately 1:1, although the positions of the peaks are slightly different by chemical shift due to the difference of the structures. From the above results, it was confirmed that cubic boron nitride having high crystal quality can be obtained by the present method.

### EXAMPLE 2

In a microwave plasma apparatus as shown in Figure 2, a silicon substrate 1 was put on a substrate holder 2, and a reaction chamber 3' made of silica glass was evacuated to 0.001 Torr by an evacuation pump 5. Then, from a gas supplier 6, 70 sccm of Ar, 100 sccm of N₂, 90 sccm of He, 2.5 sccm of 10% BF₃/He and 0.2 sccm of H₂ were flowed through valves 7 and 7'. 450 W power of 2.45 GHz microwave was supplied from a microwave power source 11 to an applicator 16 through an isolator 13, and a plunger 17 and a stab tuner 14 were adjusted while monitoring a power meter 15, to generate a plasma in the reaction chamber 3'. In Figure 2, numeral 12 indicates a waveguide.

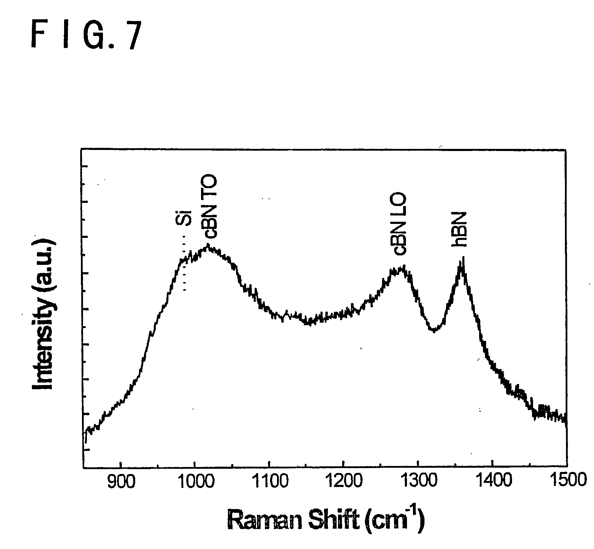

-350 V bias was applied between the substrate 1 and a counter electrode 10 from a direct-current power source 9', followed by reactions at a substrate temperature of 1080°C under 75 Torr for 1 hour, to obtain a film of cubic boron nitride on the substrate 1. The boron nitride was confirmed to be cubic boron nitride by X-ray diffraction, infrared spectroscopy and Raman spectroscopy. The Raman spectrum of the film is shown in Figure 7. The characteristic scattering peak by the longitudinal optical mode phonons at 1305 cm⁻¹ shifted to 1280 cm⁻¹, and its FWHM was about 75 cm⁻¹. The characteristic scattering peak by the transverse optical mode phonons at 1056 cm⁻¹ shifted to 1023 cm⁻¹, and its FWHM was about 75 cm⁻¹. Although the peak shifts and FWHMs were large, distinctive Raman peaks were observed.

In this microwave plasma apparatus, a reactor of quartz tube type was employed. However, a reactor of resonator type of which the wall was made of a metal can be also employed.

### EXAMPLE 3

In a direct current plasma jet CVD apparatus as shown in Figure 1, a silicon substrate 1 was put on a substrate holder 2, and a reaction chamber 3 was evacuated to 0.01 Torr by an evacuation pump 5. Then, from a gas supplier 6, 20 slm of Ar, 1.5 slm of N₂ and 3.5 sccm of H₂ were flowed through a valve 7, and 30 sccm of 10% BF₃/Ar was flowed through a valve 7', and electric power of 5kW from a direct-current power supply 8 was supplied to a plasma torch 4, to generate a plasma. Direct-current bias of -85 V was applied to the substrate 1 by a direct-current biasing power supply 9, followed by synthesis at a substrate temperature of 1100°C under 50 Torr for 60 minutes to obtain a cubic boron nitride film on the substrate 1. The boron nitride was confirmed to be cubic boron nitride by X-ray diffraction, infrared spectroscopy and Raman spectroscopy.

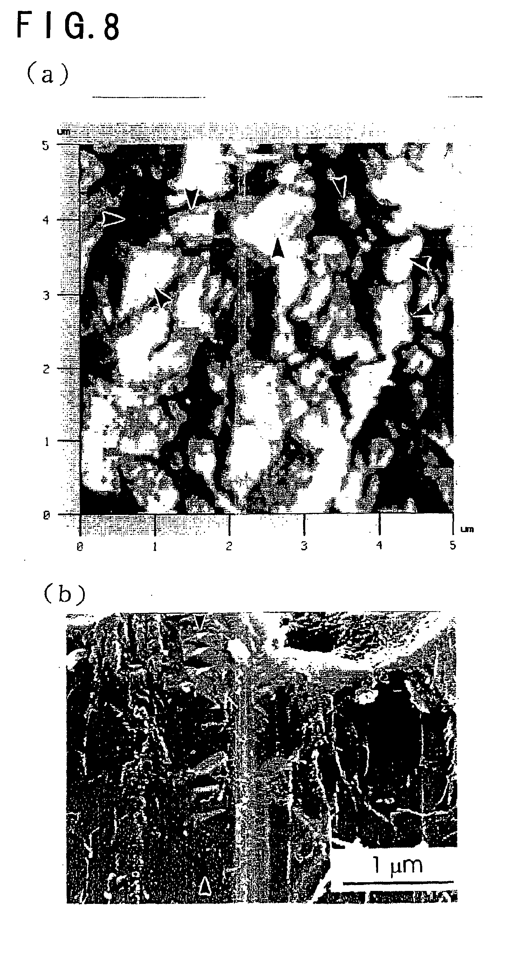

The image by atomic force microscopy of the cubic boron nitride obtained in Example 3 is shown in Figure 8(a). The crystal shapes and crystal faces are observed as indicated by arrows. In Figure 8(b) is shown an image by scanning electron microscopy of the ruptured cross-section of a cubic boron nitride film obtained under substantially the same conditions as in Example 3. As indicated between two arrows, crystal shapes and crystal faces can be observed even in the ruptured cross-section.

Cubic boron nitride has the highest hardness and thermal conductivity next to diamond, and has a low reactivity with iron family metals. Accordingly, the film of the cubic boron nitride having high crystal quality obtained by the present invention is promising for coating on cutting tools. Further, as it has high crystal quality, its intrinsic characteristics can be obtained, it may be used for preparing p- and n-semiconductors, and devices such as transistors or diodes by p-n junctions, which have been succeeded by a highpressure synthesis method, and it will be applied to devices for electronics and for optoelectronics.

## Claims

1. Cubic boron nitride which is obtained from a gas phase without using an ultra-high pressure and which distinctly shows, in the Raman spectrum, either the characteristic scattering peak of c-BN by phonons of a longitudinal optical mode at 1305 ± 35 cm⁻¹ or the characteristic scattering peak of c-BN by phonons of a transverse optical mode at 1056 ± 35 cm⁻¹, or the both characteristic scattering peaks.

2. The cubic boron nitride according to Claim 1, wherein the FWHM of the characteristic scattering peak by phonons of the longitudinal optical mode at 1305 ± 35 cm⁻¹ and the characteristic scattering peak by phonons of the transverse optical mode at 1056 ± 35 cm⁻¹, in the Raman spectrum, are at most 75 cm⁻¹.

3. The cubic boron nitride according to Claim 1, of which either a crystal shape or a crystal face or both can be observed by atomic force microscopy, by tunneling microscopy, by scanning electron microscopy, by optical microscopy, or by visual observation.

4. The cubic boron nitride according to Claim 1, wherein, in a powder X-ray diffraction pattern by using CuKα ray, the FWHM, at a diffraction angle 2 *θ*, of the diffraction peaks of 111, 200, 220 and 311 planes are at most 1.5°, 2.5°, 2.5° and 3°, respectively.

5. The cubic boron nitride according to Claim 1, wherein, in an infrared absorption spectrum, the ratio of the absorbance by cubic boron nitride component in the region of from 1050 to 1100 cm⁻¹, to the absorbance by hexagonal boron nitride, turbostratic boron nitride, or amorphous boron nitride component in the region of from 1360 to 1400 cm⁻¹, is at least 2.

6. A method for synthesizing the cubic boron nitride as defined in any one of Claims 1 to 5 from a gas phase, which comprises activating a boron source gas and a nitrogen source gas by means of plasma to deposit boron nitride, wherein fluorine gas or a fluorine-containing gas species is used as one component of the gas phase, and substrate-biasing is used.

7. The gas phase method for synthesizing the cubic boron nitride according to Claim 6, wherein the ratio of hydrogen to fluorine in the number of atoms in the gas phase is at most 2.

8. The gas phase method for synthesizing the cubic boron nitride according to Claim 6, which is carried out at a substrate temperature of from 500 to 1400°C.

9. The gas phase method for synthesizing the cubic boron nitride according to Claim 6, wherein biasing by direct current electric power or self-biasing by radio-frequency electric power, or by the both, is employed for the substrate-biasing.
